# EUROPÄISCHE PATENTSCHRIFT

(11) **EP 0 477 309 B1**
(45) Veröffentlichungstag und Bekanntmachung des Hinweises auf die Patenterteilung: **05.06.1996**
(21) Anmeldenummer: 91905806.5
(22) Anmeldetag: 22.03.1991
(51) Int. Cl.: G01R 31/00

(54) **VORRICHTUNG ZUR FUNKTIONSÜBERWACHUNG EINES ELEKTRISCHEN VERBRAUCHERS, SEINER ANSTEUERUNG UND DER DAZUGEHÖRIGEN VERBINDUNGEN**
DEVICE FOR MONITORING THE OPERATION OF AN ELECTRICAL CONSUMER, ITS CONTROL AND THE ASSOCIATED CONNECTORS
DISPOSITIF POUR CONTROLER LE FONCTIONNEMENT D'UN CONSOMMATEUR ELECTRIQUE, AINSI QUE SA COMMANDE ET LES CONNEXIONS CORRESPONDANTES

(30) Priorität: 14.04.1990 DE 4012109
(43) Veröffentlichungstag der Anmeldung: 01.04.1992
(73) Patentinhaber: ROBERT BOSCH GMBH, 70442 Stuttgart (DE)
(72) Erfinder: OTT, Karl, D-7145 Markgröningen (DE); MAYER, Rudi, D-7143 Vaihingen/Enz (DE); DENZ, Helmut, D-7000 Stuttgart 1 (DE); STRÖBELE, Hans-Peter, D-7000 Stuttgart 1 (DE); PALESCH, Reinhard, D-7147 Eberdingen-Hochdorf (DE); ECKHARDT, Jürgen, D-7141 Schwieberdingen (DE)
(86) Internationale Anmeldenummer: DE9100255
(87) Internationale Veröffentlichungsnummer: WO9116637

(56) Entgegenhaltungen:
- EP-A- 0 080 425
- WO-A-87/07388
- DE-A- 3 121 645

## Beschreibung

### Stand der Technik

Die Erfindung betrifft eine Vorrichtung zur Funktionsüberwachung eines elektrischen/elektronischen Verbrauchers.

Aus der WO/A-87/07388 ist eine Vorrichtung zur Funktionsüberwachung von elektronischen Verbrauchern bekannt. Bei diesen wird durch Vergleich des Schaltzustandes der Endstufe und des Potentials des Verbindungspunkts zwischen Endstufe und Verbraucher ein Masseschluß bzw. ein Kurzschluß oder eine Leitungsunterbrechung erkannt.

Diese Vorrichtung kann zwischen Leitungsunterbrechungen und Kurzschlüssen nach Masse nicht unterscheiden. Desweiteren verfügt diese Vorrichtung über keine Fehlerabspeicherung, das heißt, es ist nur eine On-Line-Fehlererkennung möglich. Desweiteren werden zur Fehlerfindung und Fehlererkennung von Fehlerpfad und Fehlerart umfangreiche Softwaresuchroutinen benötigt.

Weitere Vorrichtung zur Funktionsüberwachung von elektronischen Verbrauchern sind aus der EP-A-0 080 425 und der DE-A-31 21 645 bekannt.

### Aufgabe der Erfindung

Der erfindungsgemäßen Vorrichtung liegt die Aufgabe zugrunde, zwischen Masseschlüssen und Lastabfall zu erkennen.

### Vorteile der Erfindung

Die erfindungsgemäße Vorrichtung zur Funktionsüberwachung eines elektrischen Verbrauchers, seiner Ansteuerung und der dazugehörigen Verbindungen hat demgegenüber den Vorteil, daß bei einem geringen Hardware- und Softwareaufwand -insbesondere ohne Suchroutine-, die möglichen Fehlerfälle, "Kurzschluß nach Masse", "Kurzschluß nach Plus-Potential", sowie "Lastabfall" sicher unterschieden werden können. Eine ordnungsgemäße Funktion von Verbraucher und Ansteuerung wird ebenfalls erkannt. Die Verbraucher können dabei sowohl an Masse liegen und von einem sogenannten High-Side-Schalter angesteuert werden, als auch an Plus-Potential liegen und von einem sogenannten Low-Side-Schalter angesteuert werden. Es können dabei invertierende und nichtinvertierende Endstufen überwacht werden. überdies kann die erfindungsgemäße Vorrichtung nachträglich in eine vorhandene Steuerschaltung eingesetzt werden. Das Gesamtkonzept Endstufe und Funktionsüberwachungsschaltung sowie jede einzelne Komponente ist diskret aufbaubar, hybridisierbar und integrierbar.

Die Vorrichtung der eingangs genannten Art mit den in Anspruch 1 genannten Merkmalen weist wenigstens eine parallel zu der der Ansteuerung des Verbrauchers dienenden Endstufe liegende Fehler-Erfassungs-Schaltung auf. Durch hardwaremäßigen Vergleich der Eingangs- und Ausgangspotentiale sind die eingangs aufgeführten Fehler unterscheidbar. Zur Lastabfallerkennung wird die Endstufe mit einem weiteren Potential beaufschlagt, welches sich bei Abfall einer Verbindungsleitung zum Verbraucher an der Endstufe einstellt und ausgewertet werden kann. Dieses Potential kann z.B. mit einer Spannungsquelle und einem Innenwiderstand, einer OP- bzw. Komparatorschaltung oder mit einer Stromquelle usw. realisiert werden. Dadurch, daß die Funktionsüberwachungsschaltung parallel zur Endstufe des Verbrauchers geschaltet wird, bedarf es keinerlei Eingriffe in die Steuerschaltung zur Überwachung der Funktion des Verbrauchers, der Endstufe und der dazugehörigen Verbindungen. Diese Schaltung kann also einfach nachgerüstet werden. Sie ist überdies einfach aufgebaut, so daß die Vorrichtung kostengünstig herstellbar ist.

Bevorzugt wird ein Ausführungsbeispiel der Funktionsüberwachungsschaltung, bei der der Fehler-Erfassungslogik ein Speicher zugeordnet wird. Dadurch, daß Fehler in einem Speicher niedergelegt werden, kann eine asynchrone Fehlerabfrage -also unabhängig vom Auftritt des Fehlers- erfolgen. Der Speicher kann so angeordnet sein, daß er gleichzeitig als Ausgabeeinheit dienen kann, z.B. als Schieberegister für eine nachfolgende serielle Schnittstelle oder als Ausgangslatch für eine parallele Schnittstelle. Die Funktion der Steuerschaltung wird dadurch nicht beeinträchtigt, da der Fehler nicht on-line bearbeitet werden muß.

Überdies wird ein Ausführungsbeispiel der Funktionsüberwachungsschaltung bevorzugt, bei dem zwischen dem Speicher und der Fehler-Erfassungslogik ein Zwischenspeicher vorgesehen ist. In diesen werden Fehler unmittelbar nach deren Erkennung gespeichert. Gleichzeitig wird das Auftreten eines Fehlers an einem Port der Funktionsüberwachungsschaltung durch ein entsprechendes Signal gemeldet. Auf Abfrage des Steuergerätes wird der Fehler aus dem Zwischenspeicher in den Speicher übertragen und von diesem an das Steuergerät gemeldet. Diese Ausführungsform hat den Vorteil, daß bei gestörter Fehlerübertragung zur Steuerschaltung der Fehlerstatus erneut aus dem Zwischenspeicher in den Speicher geladen werden kann und dann erneut übertragen wird. Weiterhin ist der Zwischenspeicher von der Fehler-Erfassungslogik überschreibbar, das heißt, auch der Zwischenspeicher wird zurückgesetzt, falls der Endstufenfehler nicht mehr auftritt. Bei einer Fehlerartänderung wird der aktuelle Fehler in den Zwischenspeicher geschrieben. Dies hat den Vorteil, daß die Steuerschaltung jederzeit auf den aktuellen Fehlerstatus zugreifen kann.

Bevorzugt wird überdies eine Ausführungsform der Funktionsüberwachungsschaltung, bei der dem Zwischenspeicher eine Einrichtung zur Zeitverzögerung zugeordnet ist. Dies hat den Vorteil, daß Unplausibilitäten zwischen Endstufen-Ein- und -Ausgang, verursacht durch z.B. Laufzeiten in der Endstufe, ausgeblendet werden und nicht als Fehlermeldung erscheinen. Ebenso können auch Verbraucher mit langsam abklingendem Einschaltstrom, beispielsweise Lampenendstufen, mit Hilfe dieser Vorrichtung überwacht werden. Durch den zunächst sehr hohen Einschaltstrom könnte fälschlich ein Kurzschluß des Verbrauchers angenommen werden. Da ein Fehlerfall jedoch erst nach Ablauf der Verzögerungszeit des Zeitgliedes in den Zwischenspeicher eingelesen wird, kann der Einschaltstrom zunächst abklingen.

Nach einer Weiterbildung der Erfindung kann die Vorrichtung zur Funktionsüberwachung mit einem Kodierer ausgerüstet sein, der der Fehler-Erfassunglogik nachgeordnet ist. Da zwei oder mehr Fehlerarten nicht gleichzeitig auftreten können, kann die Fehlerart mit Hilfe einer Kodierschaltung kodiert werden, wodurch Speicherplatz in dem Zwischenspeicher/Speicher eingespart werden kann. Zudem benötigt ein Auslesezyklus des Speichers, der reduzierten Bitanzahl entsprechend, geringeren Zeitaufwand.

Weitere Ausgestaltungen und Vorteile der Erfindung ergeben sich aus den übrigen Unteransprüchen. Besonders vorteilhaft ist es, wenn die Vorrichtung zur Funktionsüberwachung mit einer Sicherheitsschaltung versehen ist, die im Fehlerfall die Endstufe mit einem Steuersignal beaufschlagt, wodurch die Endstufe und der Verbraucher abgeschaltet werden. Dadurch kann eine Zerstörung der Endstufe bei Überlast, z.B. bei einem Kurzschluß nach Plus-Potential (bei Low-Side-Schalter) oder nach Masse (bei High-Side-Schalter) vermieden werden.

In dem Ausführungsbeispiel der Funktionüberwachungsschaltung wird eine Schaltungsvariante bevorzugt, bei der bei Auftritt eines Fehlers ein Port der Funktionsüberwachungsschaltung mit einem Signal beaufschlagt wird (z.B. der Ausgang der seriellen Schnittstelle), so daß der Fehlerauftritt sofort der übergeordneten Steuerschaltung gemeldet wird und die Steuerschaltung ein Auslesen des Fehlerspeichers veranlassen kann.

### Zeichnung

Die Erfindung wird im folgenden anhand der Zeichnung näher erläutert. Es zeigen:
- Figur 1: eine Prinzipskizze einer Funktionsüberwachungsschaltung;
- Figur 2: ein Blockschaltbild der Funktionsüberwachungsschaltung;
- Figur 3: ein mögliches Impulsdiagramm eines Fehlerübertragungsprotokolls (hier beispielsweise für eine serielle Schnittstelle) der Funktionsüberwachungsschaltung und
- Figur 4: eine Skizze einer Kaskade von Funktionsüberwachungsschaltungen.

### Beschreibung der Ausführungsbeispiele

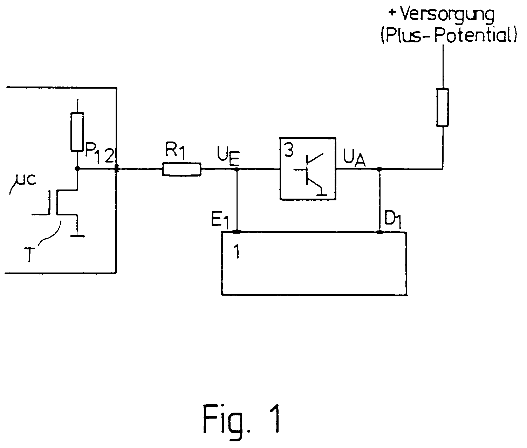

Aus der Prinzipskizze gemäß Figur 1 ist das Prinzip der Fehlererkennung ableitbar. Eine Vorrichtung zur Funktionsüberwachung eines elektrischen Verbrauchers, eine Funktionsüberwachungsschaltung 1, ist parallel zu einer durch ein Verstärkersymbol 3 angedeuteten Endstufe eines Verbrauchers R geschaltet. Dabei ist die Eingangsklemme E₁ der Funktionsüberwachungsschaltung 1 mit dem durch U_{E} angedeuteten Eingang und die Klemme D₁ der Funktionsüberwachungsschaltung 1 mit dem durch U_{A} gekennzeichneten Ausgang der Endstufe 3 verbunden. Es wird im folgenden davon ausgegangen, daß es sich hier um eine nicht invertierende Endstufe handelt, jedoch ist das Fehlererkennungsprinzip auch auf invertierende Endstufe übertragbar.

Hier ist eine sogenannte "Low-Side-Endstufe" dargestellt, das heißt, der an Plus-Potential liegende Verbraucher R wird beim Einschalten über die Endstufe 3 an Masse gelegt. Das Fehlererkennungsprinzip ist jedoch ohne weiteres auch auf "High-Side-Endstufen" übertragbar.

Die Endstufe 3 wird von einer Steuerschaltung µC angesteuert (hier über einen Widerstand R₁). Aus Gründen der Übersichtlichkeit ist hier lediglich die Treiberstufe der Steuerschaltung sowie nur eine Endstufe mit Verbraucher dargestellt.

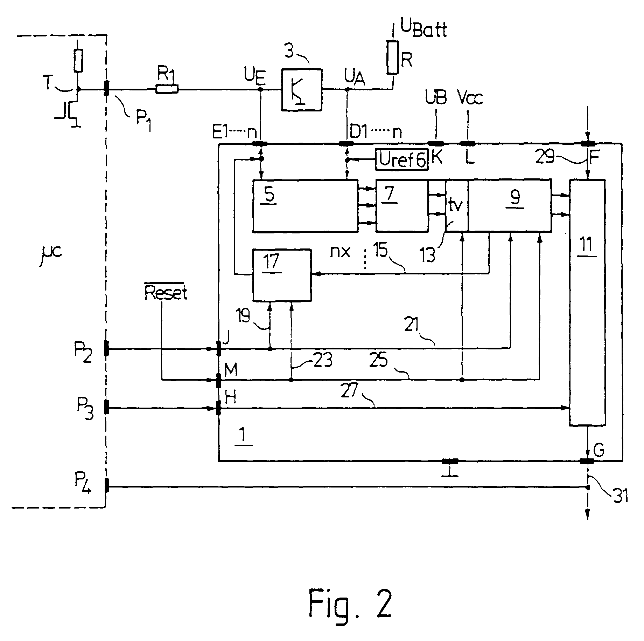

Das Blockschaltbild gemäß Figur 2 zeigt eine Funktionsüberwachungsschaltung 1, die parallel zu einer Endstufe geschaltet ist.

Der Ausgang der Endstufe 3 wird mit einer Vorrichtung zur Pegelaufschaltung 6 versehen, die eine Diode und einen sogenannten Pull-Up-Widerstand an einer versorgungsspannungsabhängigen Referenzspannung U_{ref+} aufweisen kann. Bei weiteren Ausführungsformen könnte die Vorrichtung zur Pegelaufschaltung auch z.B. aus einer Stromquelle, oder einer Operationsverstärkerschaltung, oder einer Komparatorschaltung usw. bestehen.

Die Funktionsüberwachungsschaltung 1 weist eine Fehler-Erfassungslogik 5 auf, die einerseits über einen Eingangsport E₁ mit der Eingangsklemme U_{E} der Endstufe 3 und andererseits über einen Port D₁ mit der Ausgangsklemme U_{A} der Endstufe verbunden ist. Der Port E₁ ist mit einer Schaltungseinrichtung ausgestattet, die die Endstufeneingangspegel "low" und "high" erfaßt. Der Ein-/Ausgang D₁ ist mit einer Schaltungsvorrichtung versehen, die die Endstufenausgangspegel "low", "high" und U_{ref} detektieren kann.

Die im nachfolgenden Ausführungsbeispiel angegebenen Spannungspegel beziehen sich auf eine Applikation im 12V-Automobil-Bordnetz. Sie sind als Beispiel für die Wahl von Spannungspegeln aufzufassen. Sinnvollerweise werden die Spannungspegel, abhängig vom Plus-Potential mitgeführt.

Die Fehler-Erfassungslogik der Funktionsüberwachungsschaltung 1 kann folgende Zustände (hier beispielsweise für eine nichtinvertierende LSS) unterscheiden:
1. Wenn die Eingangsklemme U_{E} der Endstufe 3 auf Low-Potential liegt und diese dadurch leitet beziehungsweise durchgeschaltet ist, wird ein Kurzschluß des Verbrauchers R zum Plus-Potential angenommen, wenn an der Ausgangsklemme U_{A} der Endstufe 3 ein Potential von >3V liegt.
2. Wenn die Eingangsklemme U_{E} der Endstufe 3 auf High-Potential liegt und dadurch die Endstufe 3 sperrt, wird ein Kurzschluß nach Masse angenommen, wenn dabei an der Ausgangsklemme U_{A} ein Potential von <3V anliegt.
3. Wenn die Eingangsklemme U_{E} der Endstufe 3 auf "High" liegt und dadurch die Endstufe 3 sperrt, wird ein Lastabfall, eine Unterbrechung der Verbraucherleitung, angenommen wenn -während die Endstufe 3 sperrt- an der Ausgangsklemme U_{A} der Endstufe das Potential U_{ref} zwischen 3V und 7V anliegt.

Es ergibt sich also, daß bei leitender Endstufe ein Potential zwischen 0V und 3V an der Ausgangsklemme U_{A} anliegt, sofern ein normaler, fehlerfreier Betrieb gegeben ist. Bei gesperrter Endstufe ist ein normaler, fehlerfreier Betrieb gegeben, wenn das Ausgangspotential an der Ausgangsklemme U_{A}>7V ist.

Aufgrund des Plus-Potentials, des Referenzpotentials und des Massenpotentials können die drei Spannungsbereiche, 0V bis 3V, 3V bis 7V und >7V, unterschieden werden. Damit können in Verbindung mit dem Eingangsspannungspegel drei Fehlerfälle, Kurzschluß nach Plus-Potential, Kurzschluß nach Masse und Lastabfall unmittelbar unterschieden werden.

Der Fehler-Erfassungslogik ist ein Kodierer 7 nachgeschaltet, der mit einem Zwischenspeicher 9 verbunden ist. Dessen Ausgangssignale werden einem Speicher 11 zugeführt, der eine an einen Ausgangsport G der Funktionsüberwachungsschaltung 1 gelegte Ausgangsklemme aufweist. Aus Figur 2 ist ersichtlich, daß der Zwischenspeicher eine Einrichtung zur Zeitverzögerung 13 aufweist. Es handelt sich hier um eine Zeitverzögerungsschaltung mit einer Verzögerungszeit tv.

Mit dem Zwischenspeicher 9 ist über eine Leitung 15 eine Sicherheitsschaltung 17 verbunden, die mit dem Eingangsport E₁ der Funktionsüberwachungsschaltung 1 und damit mit der Eingangsklemme U_{E} der Endstufe 3 verbunden ist.

Eine Eingangsklemme J der Funktionsüberwachungsschaltung ist mit einem Synchronisationsport P₂ der Steuerschaltung, eine weitere Eingangsklemme H der Funktionsüberwachungsschaltung 1 mit einem das Taktsignal abgebenden Port P₃ der Steuerschaltung µC verbunden. Schließlich ist an eine weitere Eingangsklemme M' der Funktionsüberwachungsschaltung 1 ein invertiertes Reset-Signal gelegt.

Das Synchronisationssignal wird über geeignete Leitungen 19 und 21 an die Sicherheitsschaltung 17 und an den Zwischenspeicher 9 gelegt. Ebenso wird das invertierte Reset-Signal über Leitungen 23 und 25 an die Sicherheitsschaltung 17 sowie an den Zwischenspeicher 9 und an dessen Zeitglied 13 gelegt. Schließlich wird das Taktsignal des Ports P₃ über eine Leitung 27 an den Speicher 11 gelegt.

Weitere Funktionsüberwachungsschaltungen können mit der hier dargestellten über den Port F verbunden sein, wobei von diesem Port über eine Leitung 29 eine Verbindung zum Speicher 11 besteht.

Über eine Leitung 31 besteht eine Verbindung des Ports G zu weiteren hier nicht dargestellten Funktionsüberwachungsschaltungen und zu einer seriellen Schnittstelle des µC, wobei die Leitung 31 an einem Port P₄ des µC's angeschlossen ist.

Die Funktionsüberwachungsschaltung 1 weist noch weitere Ports K und L auf, an die einerseits eine Versorgungsspannung U_{Batt} sowie eine weitere Spannung V_{cc} angelegt ist.

Bei der Darstellung in Figur 2 wurde aus Gründen der besseren Übersichtlichkeit lediglich eine Logik-Schaltung 5 vorgesehen, die mit den Ports E₁ und D₁ der Funktionsüberwachungsschaltung 1 verbunden und einer Endstufe 3 zugeordnet ist. Es ist jedoch möglich, mehrere Logik-Schaltungen, beispielsweise n Schaltungen vorzusehen, die über die übrigen Ports E₂ bis Eₙ sowie D₂ bis Dₙ mit entsprechenden Endstufen verbunden sind. Die Zahl der Kodierer 7, Zwischenspeicher 9 und Sicherheitsschaltungen 17 entspricht der der Logik-Schaltungen 5. Auch bei n Logik-Schaltungen ist allerdings lediglich ein Speicher mit entsprechenden vielen Bits 11 vorgesehen.

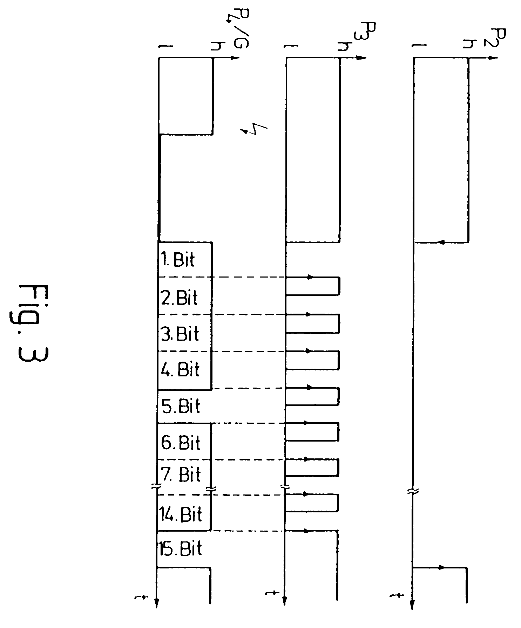

Figur 3 zeigt ein mögliches Impulsdiagramm eines Fehlerübertragungsprotokolls. Das oberste Diagramm zeigt den zeitlichen Verlauf des am Synchronisationsport P₂ des µC anliegenden Signals; das mittlere Diagramm den Potentialverlauf am Takt-Port P₃ und schließlich das unterste Diagramm den Potentialverlauf am Port G der Funktionsüberwachungsschaltung bzw. am Port P₄ des µC's.

Auf den Verlauf der Potentiale an den Ports P₂, P₃ und P₄ wird anhand der Funktionsbeschreibung der Funktionsüberwachungsschaltung 1 näher eingegangen.

Auf die Funktion der Überwachungsschaltung in Figur 2 wird im folgenden genauer eingegangen.

Mit Hilfe der Funktionsüberwachungsschaltung 1 werden die Potentiale am Eingang U_{E} und am Ausgang U_{A} der Endstufe 3 einer Plausibilitätsprüfung unterworfen. Dabei können, wie anhand von Figur 1 näher erläutert, drei Potentialbereiche und damit drei Fehlerzustände erfaßt und mit Hilfe des Fensterkomparators der Logik-Schaltung 5 unterschieden werden, nämlich ein Kurzschluß des Verbrauchers R zur Versorgungsspannung U_{Batt}, ein Kurzschluß nach Masse und Lastabfall, das heißt, eine Unterbrechung der Zuleitung zum Verbraucher R. Dazu werden die an den Klemmen E₁ und D₁ der Funktionsüberwachungsschaltung 1 liegenden Potentiale sowie die Bezugspannung U_{ref} in der Logik-Schaltung 5 miteinander verglichen.

Mit Hilfe der Fehler-Erfassungslogik 5 wird ein Fehler der Endstufe 3 erfaßt. Nach Ablauf der durch die Einrichtung 9 eingestellten Verzögerungszeit tᵥ wird gleichzeitig der Fehler in den Zwischenspeicher eingeschrieben und über einen Port (hier Port G) der Auftritt eines Fehlers zur Anzeige gebracht. Aufgrund dieser Verzögerungszeit werden fälschliche Fehlermeldungen unterbunden wie beispielsweise Unplausibilitäten zwischen Endstufen-Eingangs- und - Ausgangspotentialen z.B. aufgrund von normalen Laufzeitverzögerungen der Endstufe.

Oder beispielsweise ist bei Lampenendstufen der Einschaltstrom so groß, bzw. das Potential an der Ausgangsklemme U_{A} so hoch, daß ein Kurzschluß des Verbrauchers R nach Versorgungsspannung diagnostiziert werden könnte. Die Verzögerungszeit muß so gewählt werden, daß kurzzeitige Unplausibilitäten zwischen Ein- und Ausgang zurückgegangen bzw. daß der Einschaltstrom nach Ablauf der gewählten Verzögerungszeit abgeklungen sind. Der Fehlerfall bleibt so lange im Zwischenspeicher 9 gespeichert, bis gegebenenfalls eine Fehlerheilung eintritt. Beispielsweise bei einem Wackelkontakt kann ein zunächst gemeldeter Lastabfall zu einem späteren Zeitpunkt nicht mehr gegeben sein. Ein im Zwischenspeicher 9 abgespeicherter Fehler wird im Falle einer Fehlerheilung überschrieben, das heißt, gelöscht.

Der Port G der Funktionsüberwachungsschaltung 1 wird also unmittelbar bei Ablauf der Zeitverzögerung nach Auftreten eines Fehlers auf "Low" gesetzt. Der Fehlerfall bleibt im Zwischenspeicher 9 gespeichert. Das Steuergerät µC kann durch Abfrage an seinem Eingangsport P₄ das geänderte Potential der Ausgangsklemme G erkennen und gegebenenfalls eine Fehlerabfrage durchführen. Das heißt also, das Steuergerät kann asynchron, also unabhängig vom Eintritt des Fehlerfalles, eine Fehlerabfrage durchführen.

Dazu wird über den Synchronisationsport P₂ und die zugehörige Leitung 21 ein Signal an den Zwischenspeicher 9 abgegeben, der daraufhin die Fehlermeldung in den Speicher 11 lädt. Der Speicher 11 wird zweckmäßiger Weise zu einer Ausgangseinheit verschaltet. Dabei kann z.B. ein paralleler Ausgang oder ein serieller Ausgang verschaltet werden. Der Speicher 11 ist hier vorzugsweise als Schieberegister mit einem seriellen Ausgang verschaltet. Durch diese Anordnung wird die Anzahl der Anschlüsse der Funktionsüberwachungsschaltung reduziert.

In Figur 3 ist beispielhaft ein Übertragungsprotokoll für ein serielles "Fehlerauslesen" angegeben.

Durch ein Taktsignal am Taktport P₃, das über die Leitung 27 zum Speicher 11 gelangt, erfolgt die "Austaktung" des in den Speicher 11 geladenen Fehler-Reports, das heißt, die serielle Auslesung des Speicherinhalts.

In Figur 3 ist anhand des untersten Diagramms ersichtlich, daß die im Speicher 11 gesetzten Bits, hier die Bits 1 bis 15, nacheinander ausgelesen werden. Aus der Lage der Bits im Übertragungsprotokoll können die Fehlerart sowie der Fehlerpfad, das heißt, die Endstufe, an der ein Fehler vorliegt, ermittelt werden.

Aus Figur 3 ist ersichtlich, daß die Taktsignale an dem Port P₃ erst durch die Änderung des Potentials am Synchronisationsport P₂ abgegeben werden. Solange das Potential am Synchronisationsport P₂ auf "HIGH" liegt, hat das Taktsignal gemäß Figur 3 keinen Einfluß auf den Eingangsport P₄ der Diagnose-Schnittstelle.

Aus dem oben Gesagten ergibt sich, daß die Fehlermeldung aus dem Zwischenspeicher 9 in den Speicher 11 übertragen wird. Grundsätzlich werden vier Meldungen unterschieden, kein Fehler, Kurzschluß nach Plus-Potential, Kurzschluß nach Masse und Lastabfall. Entsprechend müßten für jede Logik-Schaltung 5 also auch vier Bits sowohl im Zwischenspeicher 9 als auch im Speicher 11 vorgesehen werden. Oben wurde angegeben, daß in der Funktionsüberwachungsschaltung 1 bis zu n Logik-Schaltungen, also auch 4·n Bits im Zwischenspeicher vorgesehen werden können. Entsprechend viele Bits müßten auch im Speicher 11 vorgesehen werden.

Da zwei Endstufenfehler nicht gleichzeitig an einer Endstufe auftreten können, werden bei dem hier dargestellten Ausführungsbeispiel die Fehler nach folgender Tabelle kodiert:

| Fehlerart | Bit | Bit |
|---|---|---|
| kein Fehler | 1 | 1 |
| KS nach Plus-Potential | 0 | 0 |
| Lastabfall | 1 | 0 |
| KS nach Masse | 0 | 1 |

Hier wird mit KS ein Kurzschlußfall bezeichnet.

Diese Kodierung wird in dem Kodierer 7 vorgenommen, der zwischen der Fehler-Erfassungslogik 5 und dem Zwischenspeicher 9 angeordnet ist. Auf diese Weise wird sowohl im Zwischenspeicher 9 als auch im Speicher 11 die Anzahl der erforderlichen Bits pro Fehler-Erfassungslogik 5 auf zwei reduziert.

Bei sieben Endstufen müssen also lediglich vierzehn Bits im Speicher 11 vorgesehen werden.

Um die Diagnose-Schnittstelle auf eine fehlerfreie Übertragung des Fehlerreports aus dem Speicher 11 an die Steuerschaltung µC zu prüfen, wird ein zusätzliches Bit am Ende des Registers 11 vorgesehen, welches als letztes Bit, als Bit 15 in Figur 3, auch am Port P₄ der seriellen Schnittstelle erscheinen muß. Bei einem Fehlerübertragungsprotokoll muß dieses letzte zusätzliche, fünfzehnte Bit "LOW" sein, wenn eine fehlerfreie Übertragung stattgefunden hat. Dies ist im untersten Diagramm gemäß Figur 3 angedeutet.

Sollte bei der Abfrage des Fehlerübertragungsprotokolls das Prüfbit nicht "LOW" sein, so kann durch eine Signalfolge gemäß Figur 3 noch einmal das im Zwischenspeicher 9 gespeicherte Fehlerübertragungsprotokoll in den Speicher 11 übertragen und von dort abgefragt werden.

Bei der Übertragung des Fehlerprotokolls aus dem Speicher 11 werden die Bits seriell abgefragt. Dadurch kann eine eindeutige Zuordnung der Fehlerbits zu der zugehörigen FehlerErfassungslogik 5 bzw. zur entsprechenden Endstufe 3 vorgenommen werden. Aus dem Fehlerübertragungsprotokoll kann also ohne weiteres ermittelt werden, an welcher der der Funktionsüberwachungsschaltung 1 zugeordneten Endstufe ein Fehler aufgetreten ist und welcher Art der dort vorhandene Fehler ist. Es kann also eine eindeutige Fehlerzuordnung und -unterscheidung erfolgen.

Die Funktionsüberwachungsschaltung 1 ist zusätzlich mit einer Sicherheitsabschaltung 17 versehen, die hier über die Leitung 15 mit dem Zwischenspeicher 9 verbunden ist. Bei Auftritt eines Kurzschlusses, welcher die Endstufe beschädigen könnte (Kurzschluß nach Versorgungsspannung bei Low-Side-Schalter bzw. Kurzschluß nach Masse bei High-Side-Schalter), wird ein Signal über diese Leitung an die Sicherheitsabschaltung gegeben, die daraufhin die zugehörige Endstufe 3 abschaltet. Bei dem hier dargestellten Ausführungsbeispiel wird die Eingangsklemme der Endstufe auf einen Pegel gelegt, der eine inaktive Endstufe gewährleistet. Auf diese Weise wird auch bei einem Kurzschluß nach Masse bzw. zur Versorgungsspannung der Verbraucher R sofort abgeschaltet, so daß eine Beschädigung praktisch ausgeschlossen ist. Durch die Abschaltverzögerung sollte die Endstufe für kurze Zeit kurzschlußfest sein, damit Schäden bis zur Abschaltung durch die Sicherheitsschaltung 17 vermieden werden.

Die einmal abgeschaltete Endstufe wird beim Auslesen des Fehlerübertragungsprotokolls aus dem Speicher 11 durch Verbindungsleitung 19 und Sicherheitsabschaltung 17 wieder freigegeben. Der Fehlerfall "Kurzschluß nach Plus-Potential" bleibt jedoch im Zwischenspeicher 9 gespeichert, bis er durch eine eventuelle Federheilung zurückgesetzt wird. Solange der Fehler vorliegt, wird die Endstufe nach jedem Auslesevorgang wieder abgeschaltet. Durch das invertierte Reset-Signal am Eingangsport M der Funktionsüberwachungsschaltung 1 können alle Fehler- bzw. Zwischenspeicher 9 definiert zurückgesetzt werden. Dazu wird das Reset-Signal über die Leitung 25 an die Zwischenspeicher 9 weitergeleitet.

Durch das invertierte Reset-Signal kann die Funktionsüberwachungsschaltung 1 auch initialisiert werden bzw. definiert abgeschaltet werden. Dazu wird zusätzlich das Reset-Signal über die Leitung 23 an die der Endstufenabschaltung dienende Sicherheitsabschaltung geleitet, das heißt, die Endstufe inclusive Verbraucher werden abgeschaltet, indem ein entsprechender Eingangspegel an die Endstufe gelegt wird.

Verbraucher, die bei der Initialisierung der Funktionsüberwachungsschaltung nicht abgeschaltet werden sollen oder dürfen, werden entsprechend vom Steuergerät angesteuert, das heißt, der zwischen dem Ausgangsport P₁ des Steuergeräts µC und der Eingangsklemme U_{E} der Endstufe liegende Widerstand R₁ entfällt bei diesen Endstufen. Er wird statt dessen in die Verbindungsleitung zwischen der Eingangsklemme U_{E} der Endstufe und dem zugehörigen Port E₁ der Funktionsüberwachungsschaltung 1 gelegt. Dies führt dazu, daß auch bei einer Aktivierung der Sicherheitsschaltung 17 der zugehörige Verbraucher nicht abgeschaltet wird.

Zusätzlich kann aus Sicherheitsgründen bei einem gesetzten Reset-Signal die Endstufe über die Sicherheitsschaltung 17 abgeschaltet werden, damit undefinierte Potentiale an den Ausgangsports der Steuerschaltung µC nicht zu Fehlfunktionen der Verbraucher führen.

Insgesamt ist erkennbar, daß durch eine hier dargestellte Fehlerüberwachungsschaltung 1 Fehler den einzelnen Endstufen zugeordnet und unterschieden werden können.

Es ist ohne weiteres ersichtlich, daß die Funktionsüberwachungsschaltung problemlos den Endstufen von Verbrauchern zugeordnet werden kann, weil lediglich eine Parallelschaltung vorgesehen ist. Es bedarf keinerlei Eingriffe in die zugehörige Endstufe. Auf diese Weise kann die hier beschriebene Funktionsüberwachungsschaltung einfach und universell eingesetzt werden. Mit Hilfe der beschriebenen Schaltung werden einfache und damit preiswerte Endstufenbausteine kurzschlußfest und diagnostizierbar.

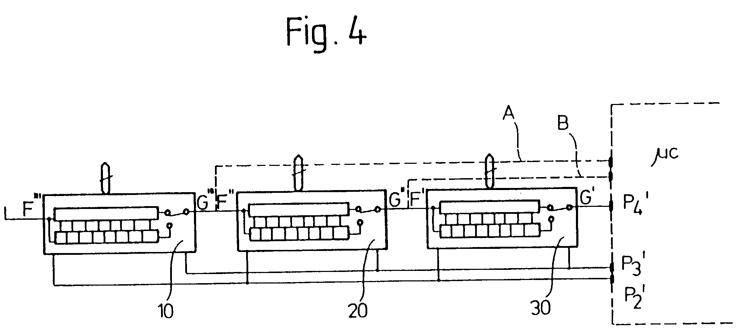

Schließlich ist noch festzuhalten, daß Fehlerüberwachungsschaltungen, wie sie hier beschrieben sind, kaskadierbar sind. Eine mögliche Kaskadenschaltung ist in Figur 4 dargestellt.

Bei dem hier dargestellten Ausführungsbeispiel sind drei Fehlerüberwachungsschaltungen 10, 20, 30 einem Steuergerät µC zugeordnet. Die Endstufen der wichtigsten Verbraucher, sind der Überwachungsschaltung 30 zugeordnet, die unmittelbar an das Steuergerät µC angeschlossen ist. Dabei ist der Ausgangsport G' dieser Überwachungsschaltung dem Eingangsport P₄' der Steuerschaltung zugeordnet. Damit wird bezweckt, daß die Fehlermeldung der wichtigsten Endstufen bei einer Abfrage zuerst verfügbar sind. An dem Port F' der Fehlerüberwachungsschaltung 30 ist die Ausgangsklemme G'' der Fehlerüberwachungsschaltung 20 angeschlossen. Entsprechend ist an dem Port F'' der Fehlerüberwachungsschaltung 20 der Ausgangsport G''' der Fehlerüberwachungsschaltung 10 angeschlossen.

Ein Taktsignal wird über den Port P₃' der Steuerschaltung an alle Fehlerüberwachungsschaltungen gelegt, ebenso ein am Port P₂' der Steuerschaltung anliegendes Synchronisationsignal.

Sobald von einer der Fehlerüberwachungsschaltungen ein Fehler erfaßt wird, wird das Potential "LOW" am Port P₄' der Steuerschaltung µC angelegt. Die Fehlerabfrage erfolgt entsprechend den Erläuterungen zu Figur 2, das heißt, die in den Fehlerschaltungen 10, 20 und 30 vorhandenen Fehler werden seriell aus den entsprechenden Speichern ausgetastet, wie das anhand von Figur 2 und dem zugehörigen Speicher 11 erläutert wurde.

Durch gestrichelte Leitungen A und B ist dargestellt, daß zur Verkürzung der Auslesezeit die in den Fehlerüberwachungsschaltungen 10, 20, 30 vorhandenen Fehlerprotokolle auch parallel von der Steuerschaltung µC abgefragt werden können.

## Patentansprüche

1. Vorrichtung zur Funktionsüberwachung eines als Endstufe ausgebildeten elektrischen/elektronischen Schalters, seines angeschlossenen Verbrauchers, seiner Ansteuerung und seiner dazugehörigen Verbindungsleitungen,
- mit wenigstens einer parallel zur Endstufe (3) geschalteten Fehlererfassungslogik (5),
dadurch gekennzeichnet,
- daß der Verbindungspunkt zwischen dem Schalter und dem Verbraucher mit einem Bezugspotential (U_{Ref}) beaufschlagt wird,
- daß an die Fehlererfassungslogik die Potentiale (UE, UA) der Eingangs- und Ausgangsklemme der Endstufe (3) sowie das Bezugspotential (U_{Ref}) anlegbar sind,
- daß die Fehlererfassungslogik ausgehend von den anliegenden Potentialen zwischen den Fehlern Kurzschluß nach Pluspol, Lastabfall und Kurzschluß nach Masse unterscheidet,
- und daß eine Zusatzschaltung für die Speicherung des Fehlerstatusses und das Einlesen eines Fehlerprotokolls durch ein Steuergerät vorgesehen ist

2. Vorrichtung nach Anspruch 1, dadurch gekennzeichnet, daß die Endstufe (3) als invertierende, nichtinvertierende, Low-Side- oder High-Side-Endstufe ausgebildet ist.

3. Vorrichtung nach Anspruch 1, gekennzeichnet durch einen der Logik-Schaltung (5) zugeordneten Speicher (11), in dem ein Fehlerfall speicherbar ist.

4. Vorrichtung nach Anspruch 3, gekennzeichnet durch einen dem Speicher (11) zugeordneten Zwischenspeicher (9).

5. Vorrichtung nach Anspruch 4, dadurch gekennzeichnet, daß der Zwischenspeicher (9) eine Zeitverzögerung (13) aufweist.

6. Vorrichtung nach einem der Ansprüche 1 bis 5, dadurch gekennzeichnet, daß der Fehler-Erfassungslogik (5) ein Kodierer (7) nachgeordnet ist.

7. Vorrichtung nach einem der Ansprüche 1 bis 6, gekennzeichnet daß wenigstens eine Sicherheitsschaltung (17) vorgesehen ist, die der Endstufe (3) zugeordnet ist und die im Fehlerfall von der Fehler-Erfassungslogik (5), dem Zwischenspeicher (9) und/oder dem Speicher (11) mit einem Steuersignal beaufschlagbar ist.

8. Vorrichtung nach einem der Ansprüche 1 bis 7, dadurch gekennzeichnet, daß der Speicher (11) mit einem Port (P₄) oder einer parallelen Schnittstelle mit der Steuerschaltung (µC) verbunden ist, über die der Inhalt des Speichers auslesbar ist.

9. Vorrichtung nach einem der Ansprüche 1 bis 8, gekennzeichnet durch mehrere, jeweils einer Endstufe eines Verbrauchers zugeordnete Fehler-Erfassungslogikschaltungen, die - vorzugsweise über einen Kodierer und/oder einen Zwischenspeicher - mit dem Speicher verbunden sind.

10. Vorrichtung nach einem der Ansprüche 1 bis 9, dadurch gekennzeichnet, daß sie mit Vorrichtungen gleicher Art kaskadierbar ist.

11. Vorrichtung nach einem der Ansprüche 1 bis 10, dadurch gekennzeichnet, daß der Auftritt eines Fehlers direkt, durch ein entsprechendes Signal, an einem Ausgang angezeigt wird.

## Claims

1. Device for monitoring the function of an electric/electronic switch formed as an output stage, its connected load, its drive and its associated connecting lines,
- having at least one fault acquisition logic (5) connected in parallel with the output stage (3),
- characterised in that a reference potential (U_{Ref}) is applied to the connection point between the switch and the load,
- in that the potentials (UE, UA) of the input terminal and output terminal of the output stage (3) and the reference potential (U_{Ref}) can be applied to the fault acquisition logic,
- in that, on the basis of the potentials applied, the fault acquisition logic distinguishes between the faults of short circuit to positive pole, load drop-out and short circuit to earth,
- and in that an additional circuit is provided for storing the fault status and for reading in a fault protocol by means of a control device.

2. Device according to Claim 1, characterised in that the output stage (3) is formed as an inverting, non-inverting, low-side or high-side output stage.

3. Device according to Claim 1, characterised by a memory (11) associated with the logic circuit (5), in which a fault case can be stored.

4. Device according to Claim 3, characterised by a buffer store (9) allocated to the memory (11).

5. Device according to Claim 4, characterised in that the buffer store (9) has a time delay (13).

6. Device according to one of Claims 1 to 5, characterised in that the fault acquisition logic (5) is followed by a coder (7).

7. Device according to one of Claims 1 to 6, characterised in that at least one safety circuit (17) is provided, which is allocated to the output stage (3) and to which, in the case of a fault, a control signal can be applied by the fault acquisition logic (5), the buffer store (9) and/or the memory (11).

8. Device according to one of Claims 1 to 7, characterised in that the memory (11) is connected to a port (P₄) or a parallel interface to the control circuit (µC) via which the content of the memory can be read out.

9. Device according to one of Claims 1 to 8, characterised by several fault acquisition logic circuits in each case allocated to one output stage of a load, which are connected to the memory, preferably via a coder and/or a buffer store.

10. Device according to one of Claims 1 to 9, characterised in that it can be cascaded with devices of the same type.

11. Device according to one of Claims 1 to 10, characterised in that the occurrence of a fault is directly indicated at an output by means of a corresponding signal.

## Revendications

1. Dispositif de contrôle du fonctionnement d'un commutateur électrique/électronique en forme d'étage de puissance, du consommateur relié à celui-ci, de sa commande et ses connexions, comprenant :
- au moins une logique de détection d'erreur (5) branchée en parallèle sur l'étage de puissance (3),
caractérisé en ce que :
- le point de jonction entre le commutateur et le consommateur est mis à un potentiel de référence (U_{ref}),
- la logique de détection de défaut peut recevoir les potentiels (UE, UA) de la borne d'entrée et de la borne de sortie de l'étage de puissance (3) ainsi que la tension de référence (U_{ref}) ,
- la logique de détection de défaut, partant des potentiels appliqués permet de distinguer entre les défauts de court-circuit vers le potentiel positif, la coupure de la charge et le court-circuit à la masse,
- et en ce qu'un circuit complémentaire est prévu pour enregistrer les états de défaut et inscrire un protocole de défaut à l'aide de l'appareil de commande.

2. Dispositif selon la revendication 1, caractérisé en ce que l'étage de puissance (3) est en forme d'étage de puissance de niveau bas ou de niveau haut, inversé ou non inversé.

3. Dispositif selon la revendication 1, caractérisé par une mémoire (11) associée à la logique (5) et qui permet d'enregistrer les défauts.

4. Dispositif selon la revendication 3, caractérisé par une mémoire intermédiaire (9) associée à la mémoire (11).

5. Dispositif selon la revendication 4, caractérisé par une temporisation (13) associée à la mémoire intermédiaire (9).

6. Dispositif selon l'une des revendications 1 à 5, caractérisé en ce que la logique de détection de défaut (5) est suivie d'un codeur (7).

7. Dispositif selon l'une des revendications 1 à 6, caractérisé par au moins un circuit de sécurité (17) associé à l'étage de puissance (3) et qui en cas de défaut reçoit un signal de commande de la logique de détection de défaut (5), de la mémoire intermédiaire et/ou de la mémoire (11).

8. Dispositif selon l'une des revendications 1 à 7, caractérisé en ce que la mémoire (11) est reliée à un port (P₄) ou à une interface parallèle au circuit de commande (µC), permettant de lire le contenu de la mémoire.

9. Dispositif selon l'une des revendications 1 à 8, caractérisé par plusieurs circuits logiques de détection de défaut associés chaque fois à un étage de puissance d'un consommateur et qui sont reliés à la mémoire (de préférence par un codeur et/ou une mémoire intermédiaire).

10. Dispositif selon l'une des revendications 1 à 9, caractérisé en ce qu'il peut être mis en cascade avec des dispositifs de même type.

11. Dispositif selon l'une des revendications 1 à 10, caractérisé en ce que l'occurrence d'un défaut est affichée directement à une sortie par un signal correspondant.
